# EUROPÄISCHE PATENTSCHRIFT

(11) **EP 1 760 886 B1**
(45) Veröffentlichungstag und Bekanntmachung des Hinweises auf die Patenterteilung: **20.04.2011**
(21) Anmeldenummer: 06017104.8
(22) Anmeldetag: 17.08.2006
(51) Int. Cl.: H03K 17/96

(54) **Sensorvorrichtung**
Sensor device
Dispositif de capteur

(30) Priorität: 19.08.2005 DE 202005013420 U
(43) Veröffentlichungstag der Anmeldung: 07.03.2007
(73) Patentinhaber: E.G.O. Control Systems GmbH, 72336 Balingen (DE)
(72) Erfinder: Weiss, Josef, 78586 Deilingen (DE)
(74) Vertreter: Patentanwälte Ruff, Wilhelm, Beier, Dauster & Partner

(56) Entgegenhaltungen:
- EP-A- 1 418 491
- FR-A- 2 830 999
- US-A- 4 561 002

## Beschreibung

### Anwendungsgebiet und Stand der Technik

Die Erfindung betrifft eine Sensorvorrichtung zur Erzeugung eines Schaltsignals bei Annäherung und/oder Berührung eines Schaltbereichs.

Die DE 30 36 050 C2 zeigt ein kapazitives System mit einer dielektrischen Platte, wobei der Sensor eine auf einer Seite der Platte liegende Elektrode aufweist, die bereichsmäßig zwei auf der anderen Seite der Platte liegende Elektroden überdeckt, von denen die eine die andere ringförmig umgibt.

Die EP 859 467 B1 beschreibt eine Sensorvorrichtung mit einem aus leitfähigem Schaumstoff bestehenden kapazitiven Sensorelement, das an die Rückseite einer Blende angedrückt ist.

Die DE 201 197 00 U1 beschreibt eine Sensorvorrichtung, bei der auf der Rückseite einer durchsichtigen Blende eine elektrisch leitfähige Schicht vorgesehen ist, die mittels eines Kontaktteils kontaktiert wird.

Die US 4,561,002 beschreibt eine Sensorvorrichtung, bei der auf einer Seite einer Platine ein leitfähiges Feld angeordnet ist und auf der anderen Seite der Platine, diesem gegenüber, zwei Sensorelemente mit etwas Abstand zueinander. Das oben auf der Platte angebrachte leitfähige Feld ist so groß wie der Bereich, den die beiden unten angebrachten Sensorelemente gemeinsam überdecken. Dieses Feld bildet nach oben an einer darüber verlaufenden Abdeckung eine Berührzone. Dabei dient das Feld dazu, sozusagen ein kapazitives Überkoppeln zwischen den beiden Sensorelementen an der Unterseite zu bewirken. Dazu ist das eine Sensorelement als Sendeelektrode und das andere Sensorelement als Empfangselektrode ausgebildet und sie werden entsprechend angesteuert.

### Aufgabe und Lösung

Der Erfindung liegt die Aufgabe zu Grunde, eine Sensorvorrichtung zu schaffen, die eine große Freizügigkeit in der Gestaltung der durch die Annäherung oder Berührung aktivierten und abzudeckenden Bauteile ermöglicht und kostengünstig auch in großen Stückzahlen herzustellen und leicht zu montieren ist.

Diese Aufgabe wird durch den Anspruch 1 gelöst. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Bei der Erfindung ist auf der Vorderseite der Blende, also beispielsweise an der Außenseite bzw. außerhalb eines Haushaltsgerätes, keine Elektrode oder andere leitfähige Schicht zwingend notwendig, die insbesondere nach außen elektrisch leitfähig ist. Die Blende braucht keine Durchbrüche zu haben und kann lediglich mit einer Markierung zur Kennzeichnung des Schaltbereiches ausgestattet sein. Das leitfähige Feld, das einerseits auf der Rückseite der Blende und andererseits auf der dieser zugekehrten Seite der Platine oder Leiterplatte angeordnet ist, wirkt als ein übertragendes und das Schaltsignal konzentrierendes Zwischenglied, das den Schaltbereich auch flächenmäßig definiert und begrenzt. Es ist elektrisch nicht mit der eigentlichen Sensorfläche verbunden. Diese kann vielmehr auf der der Blende abgewandten Rückseite der Platine in galvanischer Verbindung mit den Schaltelementen angeordnet sein.

Dieses kapazitive Sensorelement, von dem genau ein Sensorelement pro Schaltbereich vorgesehen ist, beispielsweise auch eine leitfähige Schicht, die zusammen mit den Kontaktbahnen der elektronischen Schaltung aufgebracht sein kann, ist erfindungsgemäß wesentlich kleiner sein als das leitfähige

Feld auf der ihr gegenüberliegenden Seite der Platine, kann eine gänzlich andere Form haben und/oder auch flächenmäßig versetzt dazu liegen. Dies ermöglicht eine große Freiheit in der Anordnung der Schaltelemente auf der Platine. Durch die fast unmittelbare Anbringung der Platine an der Rückseite der Blende wird auch Platz gespart und die Konzentration aller elektrisch zu kontaktierenden Schaltelemente auf einer Seite der Platine erleichtert deren Herstellung und Bestückung.

Dadurch, dass das elektrisch leitende Feld als Konzentrator für die zur Schaltung genutzte elektrische Eigenschaft bei Annäherung dient, kann das sie bildende meist schichtförmige oder foliendünne Bauteil beliebige Formen haben, beispielsweise auch nach Art eines Piktogramms ausgebildet sein, das den Schaltzweck anzeigt. Die Markierung auf der Vorderseite der Blende kann diesem dann entsprechen. Trotzdem braucht das eigentliche Sensorelement auf der der Blende abgewandten Seite der Platine nicht diese Form haben, so dass beispielsweise eine Standardform der Leiterplatte auch für die unterschiedlichsten Formen des Schaltbereiches verwendet werden kann. Für verschiedene Schaltbereiche auf einer Blende kann eine gemeinsame Platine vorgesehen sein oder es können auch einzelne Platinen an der Blende angebracht oder an diese angedrückt werden.

Das elektrisch leitende Feld kann auf die Leiterplatte direkt aufgebracht sein, beispielsweise als im Negativverfahren herausgeätzte Schicht, als zusätzlich aufgelegtes Plättchen oder auch als Bedruckung mit einem elektrisch leitenden Material, beispielsweise einem kohlenstoffhaltigen Material, Silber, Kupfer oder dgl.. Auch die Aufklebung eines Folienausschnitts oder die Zwischenlage einer dielektrischen Folie mit leitfähigen Feldern darauf zwischen Platine und Blende ist möglich. Besonders bevorzugt ist eine Ausführung, bei der eine beidseitig klebende Folie (Doppelklebeband) verwendet wird, die gleichzeitig das elektrisch leitende Feld an der Leiterplatte oder direkt an der Blende festlegt und andererseits auch die Platine an der Blende festklebt. Vorteilhaft ist sowohl das leitende Feld als auch das Sensorelement selbst nur als einzelne zusammenhängende Fläche ausgebildet, benötigt also keine einander umgebende Elektroden, die zu überbrücken wären.

Das elektrisch leitende Feld könnte auch elastisch sein, insbesondere auch volumenelastisch, z.B. als elektrisch leitfähiger Schaumstoff ausgebildet sein, um Unebenheiten oder Krümmungen der Blende gegenüber der Platine auszugleichen.

Beleuchtete Tasten oder andere Signalgeberfunktionen lassen sich verwirklichen, auch ohne die Blende zu durchbrechen. So könnte auf der der Blende zugekehrten Seite der Platine eine Leuchtdiode angebracht sein oder, um diese Seite der Leiterplatte nicht elektrisch kontaktieren zu müssen, auf der anderen Seite angebracht sein und durch einen Durchbruch in der Leiterplatte eine entsprechend transparente Fläche in der Blende durchleuchten. Durch mehrere Einzel-LED und eine flache Lichtverteilungsoptik kann ein beliebiger Ausleuchtungseffekt erzielt werden. Das elektrisch leitende Feld kann auch durchbrochen sein, beispielsweise gelocht, in Gitterstruktur oder dgl.. In diesem Falle ist es auch möglich, den unmittelbaren Tastenbereich durch dieses Feld hindurch zu beleuchten, wenn die Blende entsprechend durchscheinend ausgebildet ist.

In einer weiteren, grundsätzlich etwas anderen Ausbildung der Erfindung ist das leitfähige Feld in zwei Teil-Bereiche unterteilt. Diese beiden Teil-Bereiche liegen entfernt voneinander und sind durch einen Verbindungs-Bereich miteinander verbunden, der beispielsweise die Form eines Steges haben kann. Da das leitfähige Feld die Aufgabe hat, das Berührungssignal sozusagen von dem Schaltbereich mit dem angelegten Finger weiterzugeben an das Sensorelement, wird dieses Weitergeben seitlich verschoben, und zwar von dem ersten Teil-Bereich an dem Schaltbereich zu dem zweiten Teil-Bereich über dem Sensorelement. Dazu liegt der zweite Teil-Bereich vorteilhaft gegenüber dem Sensorelement. Der erste leitfähige Teil-Bereich liegt besonders vorteilhaft ohne Überlappung mit dem Sensorelement entfernt davon, wobei der Verbindungsbereich die elektrische Verbindung bildet. Deswegen kann die Entfernung zwischen den beiden Teil-Bereichen auch sehr groß sein, beispielsweise das zwei- bis zehnfache des Durchmessers des Sensorelements oder des ersten Teil-Bereichs betragen.

In weiterer Ausgestaltung dieser Erfindung definiert der erste Teil-Bereich den Schaltbereich, wozu an der Blende über dem ersten Teil-Bereich eine Markierung vorgesehen ist. Bei den eingangs genannten Ausgestaltungen hat dies das gesamte leitfähige Feld getan. Der Schaltbereich kann so groß sein wie der erste Teil-Bereich. Die Größe des zweiten Teil-Bereichs gegenüber dem Sensorelement sollte etwa der des Sensorelements entsprechen, braucht aber auch nicht viel größer zu sein.

Die beiden Teil-Bereiche und der Verbindungs-Bereich sind vorteilhaft als eine einzige Schicht mit unterschiedlichen Breiten bzw. einem entsprechenden Konturverlauf ausgebildet. Diese Schicht ist besonders vorteilhaft in einem einzigen Verfahren aufgebracht mit der entsprechenden Kontur.

Bei einer bevorzugten Ausbildung der Sensorvorrichtung sind an der elektrisch isolierenden Platine mehrere leitfähige Felder vorhanden, die jeweils in verschiedene Teil-Bereiche aufgeteilt sind, also Teil-Bereiche mit Verbindungs-Bereichen dazwischen. Ein jeweils zu einem leitfähigen Feld zugehöriges Sensorelement liegt dabei entfernt von dem zugehörigen Schaltbereich mit dem ersten Teil-Bereich.

Bei dieser vorbeschriebenen Ausbildung handelt es sich insofern noch um eine dem allgemeinen Erfindungsgedanken des Anspruchs 1 entsprechende Ausbildung, da das leitfähige Feld sowohl am Schaltbereich als auch am Sensorelement ist. Allerdings sind als Besonderheit eben Schaltbereich und Feld voneinander entfernt worden bzw. auseinander gezogen worden und nicht mehr in einem Schichtaufbau übereinander. Durch das Auseinanderziehen ist es möglich, Design und Ausbildung der Sensorvorrichtung, insbesondere an Blenden von Elektrogeräten, stärker zu variieren. Vor allem kann das eigentliche Sensorelement nun weit von dem Schaltbereich entfernt sein.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischenüberschriften beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: einen schematischen Schnitt durch eine Sensorvorrichtung,
- Fig. 2: eine Draufsicht in Richtung des Pfeils II in Fig. 1 gesehen,
- Fig. 3: einen Schnitt entsprechend Fig. 1 durch eine Sensorvorrichtung mit einer anderen Art der Befestigung,
- Fig. 4: eine Abwandlung der Sensorvorrichtung aus Fig. 1 mit auseinandergezogenem leitfähigen Feld und
- Fig. 5: die Draufsicht auf die entsprechende Abwandlung von Fig. 4.

### Detaillierte Beschreibung der Ausführungsbeispiele

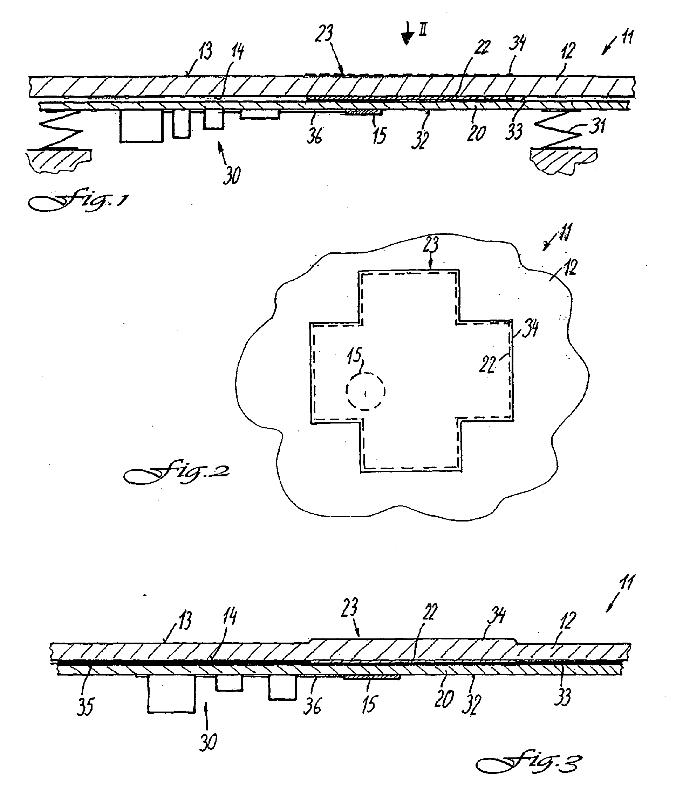

Die in den Fig. 1 und 2 dargestellte Sensorvorrichtung 11 gehört zu einem kapazitiven Berührungsschalter, der die Änderung der Kapazität durch die Annäherung oder Berührung eines Schaltbereiches 23 einer Blende 12 durch einen Körper, wie einen Finger eines Benutzers, mittels einer elektronischen Steuerung 30 oder Schaltung zu einem Schaltvorgang auswertet. Das Funktionsprinzip und die Schaltung sind in den eingangs erwähnten Druckschriften enthalten, auf die hier Bezug genommen wird.

Die Blende 12, von der nur ein kleiner Ausschnitt dargestellt ist, besteht aus nicht-metallischem, dielektrischem Material, z.B. Kunststoff, der undurchsichtig oder durchscheinend sein kann und meist thermoplastisch ist. Er ist elektrisch nicht leitend und kann entweder die Front oder ein anderes Gehäuseteil eines Elektrogerätes, wie einer Waschmaschine, eines Geschirrspülers, eines Wäschetrockners oder eines ähnlichen Haushaltsgerätes sein oder eine darin eingesetzte Blende. Die Erfindung ist aber auch an anderen Geräten, beispielsweise an Werkzeugmaschinen, Schalttafeln oder anderen Geräten, brauchbar. Die Blende 12 hat eine einem Benutzer zugekehrte Vorderseite 13 und eine Rückseite 14, an die z.B. mittels angedeuteter Federn 31 eine Platine 20, die man auch als Leiterplatte bezeichnen kann, angedrückt ist. Die aus elektrisch isolierendem Material bestehende Platine 20 hat eine die Steuerungselektronik 30 und deren einzelne Elemente in SMD-Bestückung tragende aktive Seite 32 und eine unbestückte Seite 33, die der Blende 12 zugekehrt ist. Die dem Inneren zugekehrte unbestückte Seite weist ein Sensorelement 15 auf, das aus einer elektrisch leitenden Fläche besteht, die, z.B. über übliche Leiterbahnen 36, mit der Steuerung 30 galvanisch in Verbindung steht. Das Sensorelement selbst kann ebenfalls aus einem flächigen Leiterbahnabschnitt bestehen. Die Platine braucht im vorliegenden Beispiel nicht durchbrochen zu sein, da durch die SMD-Bestückung weder Befestigungsbohrungen noch Durchkontaktierungen notwendig sind. Dies erleichtert und verbilligt die Herstellung der Leiterplatte und macht sie unempfindlicher gegen Fehlfunktion.

Auf der unbestückten Seite 33 der Platine 20 ist ein elektrisch leitfähiges Feld 22 vorgesehen. Es liegt im Bereich des auf der anderen Platinenseite 32 vorgesehenen Sensorelements 15, muss jedoch, wie zu erkennen ist, nicht zentrisch zu diesem liegen und auch nicht die gleiche Form und Größe haben. Vielmehr kann es wesentlich größer sein als das Sensorelement 15.

Das Feld 22 kann in Form einer Leiterbahn oder auf beliebige andere Weise, durch Aufkleben, Aufdrucken oder andere Techniken aus leitfähigem Material auf die Platine aufgebracht sein. Es ist flächig sowohl an die Rückseite 14 der Blende als auch an die unbestückte Seite 33 der Platine angelegt und behindert auch, da es sehr dünn sein kann, nicht die Anlage der übrigen Platinenabschnitte an der Blende 12. In den Zeichnungen sind zur Erkennbarkeit die Dickenverhältnisse weit überhöht dargestellt.

Das leitfähige Feld 22 begrenzt und definiert den Schaltbereich, der sich auf der Körperseite 13 der Blende dadurch bildet. Er kann beispielsweise die Form eines Piktogramms oder Zeichens, z.B. als "+" oder "0", geformt sein. Es ist sinnvoll, auf der Vorderseite 13 der Blende eine Markierung 34, z.B. durch Bedruckung, vorzusehen, die in Form und Größe etwa dem leitfähigen Feld entspricht. Dies ist in Fig. 2 angedeutet, wo der Schaltbereich 23 die Form eines "+" hat. Es ist zu erkennen, dass die Markierung 34 etwas größer ist als das auf der Rückseite liegende Feld 22 und dass das Sensorelement bzw. die als solches wirkende Kontaktfläche 15 wesentlich kleiner ist und exzentrisch dazu liegen kann, wie es von der Leiterplattenstruktur und Bestückung her günstig ist.

Bei der Annäherung eines Körpers an den Schaltbereich 23 werden die Kapazitätsverhältnisse der Sensoreinheit, bestehend aus elektrisch leitendem Feld 22 und Sensorelement 15, verändert, wobei das Feld 22 die kapazitive Auswirkung konzentriert durch die Leiterplatte hindurch auf das Sensorelement 15 überträgt. Es wirkt also als ein Konzentrator für das Signal.

Fig. 3 zeigt eine Ausführung, die bis auf die nachstehend erläuterten Unterschiede der Ausführung nach Fig. 1 entspricht, auf die insoweit Bezug genommen wird. Gleiche Bezugszeichen bezeichnen gleiche oder funktionsgleiche Teile.

Die Befestigung der Platine 20 an der Blende 12 geschieht bei Fig. 3 über eine doppelseitig klebende Schicht oder Schichtengruppe 35, z.B. eine Doppelklebefolie. Sie ist auf die unbestückte Seite 33 der Platine aufgeklebt und dort ist in der gemäß Fig. 1 beschriebenen Positionierung ein Plättchen, beispielsweise ein Folienausschnitt, als elektrisch leitfähiges Feld 22 aufgeklebt. In dieser Form, mit einer abziehbaren Abdeckung versehen, kann die Leiterplatte zur Montage des Elektrogerätes, zu der die Blende 12 gehört, zugeliefert werden. Sie ist dann nur noch nach Abziehen der nicht dargestellten Deckfolie an die Rückseite der Blende 12 anzukleben und befestigt damit auch das leitfähige Feld in innigem Kontakt zur Rückseite 13 der Blende 12. Dieser Kontakt ist wichtig, da Luftspalte zu einer Änderung der Kapazitätseigenschaften und damit zu Ungenauigkeiten im Ansprechverhalten des elektronischen Schalters führen könnten.

Es ist auch möglich, das leitfähige Feld 22 zwischen Leiterplatte und Doppelklebefolie 35 festzukleben, so dass die gesamte Klebefläche zur Befestigung an der Blende dienen kann.

Bei der Ausführung nach Fig. 3 ist die Markierung 34 durch eine Erhebung der Blende 12 gebildet. Es ist auch zu erkennen, dass durch den Versatz zwischen leitfähigem Feld 22 und Sensorelement 15 z.B. eine nicht dargestellte zentrale Tastenbeleuchtung angebracht werden kann, indem dort auch auf der bestückten aktiven Seite 32 der Platine 20 eine ebenfalls nicht dargestellte Leuchtdiode angebracht sein kann, die z.B. durch ein Loch in der Leiterplatte und eine entsprechende transparente Stelle der Blende hindurch die Schaltfunktion anzeigt.

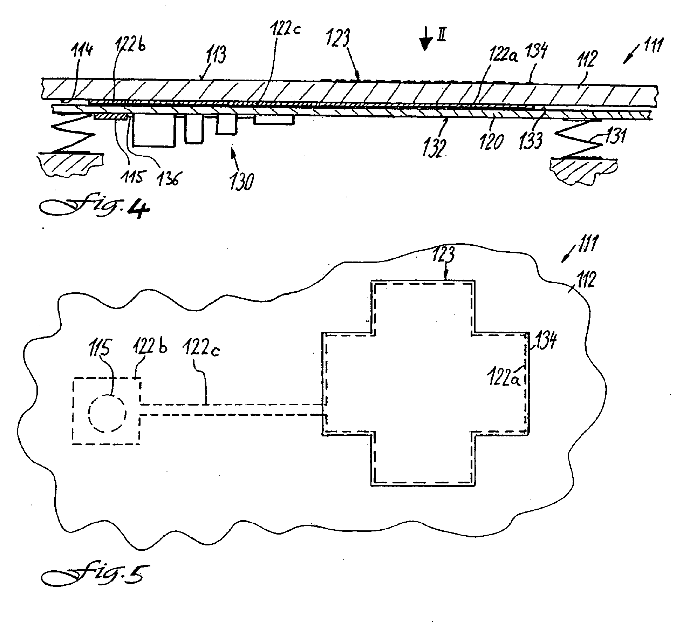

Die in den Fig. 4 in Seitenansicht und in Fig. 5 in Draufsicht dargestellte Sensorvorrichtung 111 ist eine Abwandlung derjenigen aus den Fig. 1 und 2. Sie gehört ebenfalls zu einem kapazitiven Berührungsschalter, der die Änderung der Kapazität durch die Annäherung oder Berührung eines Schaltbereiches 123 einer Blende 112 durch einen Finger eines Benutzers odgl. mit einer elektronischen Steuerung 130 oder Schaltung zu einem Schaltvorgang auswertet. Das Funktionsprinzip und die Steuerung bzw. Schaltung sind vorstehend beschrieben worden.

Im Unterschied zu der anderen Ausführung ist hier das Feld 22 unterteilt in einen ersten Teil-Bereich 122a, der unter dem Schaltbereich 123 bzw. der Markierung 134 auf der unbestückten Seite 133 der Platine 120 aufgebracht ist. Der erste Teil-Bereich 122a geht über in den Verbindungsbereich 122c, der länglich, schmal und somit stegartig bzw. wie eine Leiterbahn ausgebildet ist. Der Verbindungsbereich führt weg von dem Schaltbereich 123 nach links und geht über in einen zweiten Teil-Bereich 122b. Dieser zweite Teil-Bereich 122b liegt über dem Sensorelement 115, das wiederum ausgebildet und mit der Steuerung 130 verbunden ist wie vorstehend beschrieben. Die drei Bereiche 122a, 122b und 122c sind durch eine einzige Schicht gebildet mit einer Form bzw. Kontur gemäß Fig. 5.

Zur Funktion ist zu sagen, dass hier das durch Berührung erzeugte Signal bzw. die Signaländerung vom Schaltbereich 123 an den ersten Teil-Bereich 122a gegeben wird. Dort wird das Signal bzw. die Signaländerung von dem verbindungsgebreich 122c an den zweiten Teil-Bereich 122b übertragen. Der zweite Teil-Bereich 122b überträgt die kapazitive Auswirkung dann wiederum konzentriert durch die Leiterplatte 120 hindurch auf das Sensorelement 115. Es wirkt also ebenfalls als ein Konzentrator für das Signal vom Schaltbereich 123 wie bei der vorherigen Ausbildung. Es wird lediglich innerhalb des Feldes 122 bzw. der Teil-Bereiche das Signal seitlich weg von dem Schalt-Bereich 123 hin zu dem entfernt angeordneten Sensorelement 115 übertragen. Die vorgenannte Sensoreinheit wird weiterhin durch das Feld 122 und das Sensorelement 115 gebildet, nur eben mit sozusagen zwei Teil-Signalübertragungen. Besonders vorteilhaft ist diese Möglichkeit dann. Wenn mehrere Schaltbereiche 123 vorhanden sind, evtl. eng beisammen. Dann gibt es mehr Gestaltungsspielraum für die Anordnung der Sensorelemente, wenn sie nicht unmittelbar unter den Schaltbereichen angeordnet sein müssen.

## Patentansprüche

1. Sensorvorrichtung (11, 111) zur Erzeugung eines Schaltsignals bei Annäherung und/oder Berührung eines Schaltbereiches (23, 123) mit einem Finger oder dgl. eines Benutzers,
1.1 mit einer elektrischen Steuerung (30, 130) zur Auslösung des Schaltsignals,
1.2 mit genau einem kapazitiven Sensorelement (15, 115) pro Schaltbereich (23, 123), das mit der elektrischen Steuerung (30, 130) galvanisch verbunden ist,
1.3 mit einer Blende (12, 112) aus nicht-metallischem Material mit einer dem Benutzer zugewandten Vorderseite (13, 113) und einer Rückseite (14, 114),
1.4. mit einer elektrisch isolierenden Platine (20, 120), auf der das Sensorelement (15, 115) und die elektrische Steuerung (30, 130) angeordnet ist, und zwar auf einer dem Benutzer und der Blende (12, 112) abgewandten Seite (32, 132) der Platine (20, 120),
1.5 und mit einem leitfähigen Feld (22, 122), das auf der der Blende (12, 112) zugewandten Seite (33, 133) der Platine (20, 120) angebracht ist, ohne galvanisch mit dem Sensorelement verbunden zu sein,
1.6 wobei die Platine mit ihrer das leitfähige Feld (22, 122) tragenden Seite (33, 133) auf der Rückseite (13, 113) der Blende (12, 112) im dem Sensorelement (15, 115) gegenüberliegenden Bereich angebracht ist
1.7 wobei das leitfähige Feld (22, 122) den Schaftbereich (23, 123) definiert,
1.8 **dadurch gekennzeichnet, dass** der Schaltbereich (23, 123) und/oder das leitfähige Feld (22, 122) wesentlich größere Abmessungen haben als das Sensorelement (15, 115).

2. Sensorvorrichtung nach Anspruch 1, **dadurch gekennzeichnet, dass** der Schaltbereich (23, 123) und das leitfähige Feld (22, 122) eine andere Form und/oder Größe hat als das Sensorelement (15, 115).

3. Sensorvorrichtung nach einem der Ansprüche 1 oder 2, **dadurch gekennzeichnet, dass** das Sensorelement (15, 115) gegenüber dem leitfähigen Feld (22, 122) seitlich versetzt liegt.

4. Sensorvorrichtung nach einem der vorhergehenden Ansprüche, **dadurch gekennzeichnet, dass** zur Erzeugung mehrerer unterschiedlicher Schaltsignale mehrere gleiche Sensorelemente (15, 115) vorgesehen sind, die mit ggf. unterschiedlich großen und/oder unterschiedlich gestalteten elektrisch leitenden Feldern (22, 122) zusammenwirken.

5. Sensorvorrichtung nach einem der vorhergehenden Ansprüche, **dadurch gekennzeichnet, dass** die Platine (20, 120) und/oder das leitfähige Feld (22, 122) an die Rückseite (14, 114) der Blende (12, 112) angeklebt ist.

6. Sensorvorrichtung nach einem der vorhergehenden Ansprüche, **dadurch gekennzeichnet, dass** das leitfähige Feld (22, 122) und die Platine (20, 120) mittels einer beidseitig klebenden Schicht oder Folie (35, 135) mit der Blende (12, 112) verklebt sind.

7. Sensorvorrichtung nach einem der vorhergehenden Ansprüche, **dadurch gekennzeichnet, dass** das leitfähige Feld (122) in mindestens zwei Teil-Bereiche (122a, 122b) unterteilt ist, wobei die beiden Teil-Bereiche entfernt voneinander liegen und durch einen Verbindungs-Bereich (122c) miteinander verbunden sind.

8. Sensorvorrichtung nach Anspruch 7, **dadurch gekennzeichnet, dass** ein zweiter Teil-Bereich (122b) gegenüber dem Sensorelement (115) liegt und ein erster leitfähiger Teil-Bereich (122a) ohne Überlappung mit dem Sensorelement (115) entfernt davon liegt, vorzugsweise mit einer Entfernung vom zwei- bis zehnfachen des Durchmessers des Sensorelements (115) oder des ersten TeilBereichs (122a).

9. Sensorvorrichtung nach Anspruch 7 oder 8, **dadurch gekennzeichnet, dass** der erste Teil-Bereich (122a) den Schaltbereich (123) definiert und dazu an der Blende (112) über dem ersten Teil-Bereich (122a) eine Markierung (134) vorgesehen ist.

10. Sensorvorrichtung nach einem der Ansprüche 7 bis 9, **dadurch gekennzeichnet, dass** die beiden Teil-Bereiche (122a, 122b) und der Verbindungs-Bereich (122c) eine einzige Schicht mit unterschiedlichen Breiten bzw. Konturverlauf sind, die insbesondere in einem einzigen bzw. gleichen Verfahren aufgebracht ist.

11. Sensorvorrichtung nach einem der Ansprüche 7 bis 10, **dadurch gekennzeichnet, dass** an der elektrisch isolierenden Platine (120) mehrere Schaltbereiche (123) und leitfähige Felder (122) vorhanden sind, die jeweils in verschiedene Teil-Bereiche (122a, 122b) aufgeteilt sind, wobei jeweils ein zugehöriges Sensorelement (115) entfernt von dem zugehörigen Schaltbereich (123) liegt.

## Claims

1. Sensor device (11, 111) for generating a switching signal upon approach and/or contact of a switching area (23, 123) by a finger or the like of a user,
1.1 having an electric control unit (30, 130) for triggering the switching signal,
1.2 having exactly one capacitive sensor element (15, 115) per switching area (23, 123) galvanically connected to the electric control unit (30, 130),
1.3 having a cover (12, 112) of non-metallic material with a front side (13, 113) facing the user and a rear side (14, 114),
1.4 having an electrically insulating board (20, 120) on which is arranged the sensor element (15, 115) and the electric control unit (30, 130) on a side (32, 132) of the board (20, 120) facing away from the user and from the cover (12, 112),
1.5 and having a conductive field (22, 122) fitted to that side (33, 133) of the board (20, 120) facing the cover (12, 112) without being galvanically connected to the sensor element,
1.6 where the board with its side (33, 133) carrying the conductive field (22, 122) is fitted on the rear side (13, 113) of the cover (12, 112) in the area opposite the sensor element (15, 115),
1.7 where the conductive field (22, 122) defines the switching area (23, 123),
1.8 **characterized in that** the switching area (23, 123) and/or the conductive field (22, 122) have considerably larger dimensions than the sensor element (15, 115).

2. Sensor device according to Claim 1, **characterized in that** the switching area (23, 123) and the conductive field (22, 122) have a form and/or size different from the sensor element (15, 115).

3. Sensor device according to one of Claims 1 or 2, **characterized in that** the sensor element (15, 115) is laterally offset relative to the conductive field (22, 122).

4. Sensor device according to one of the preceding claims, **characterized in that** for generating several different switching signals, several identical sensor elements (15, 115) are provided and interact with electrically conducting fields (22, 122) of possibly differing size and/or possibly differing design.

5. Sensor device according to one of the preceding claims, **characterized in that** the board (20, 120) and/or the conductive field (22, 122) is affixed to the rear side (14, 114) of the cover (12, 112).

6. Sensor device according to one of the preceding claims, **characterized in that** the conductive field (22, 122) and the board (20, 120) are affixed to the cover (12, 112) by means of a coating or film (35, 135) adhesive on both sides.

7. Sensor device according to one of the preceding claims, **characterized in that** the conductive field (122) is subdivided into at least two part-areas (122a, 122b), where the two part-areas are at a distance from one another and are connected to one another by a connecting area (122c).

8. Sensor device according to Claim 7, **characterized in that** a second part-area (122b) is opposite the sensor element (115) and a first conductive part-area (122a) is at a distance thereto without overlapping of the sensor element (115), preferably at a distance from two to ten times the diameter of the sensor element (115) or of the first part-area (122a).

9. Sensor device according to Claim 7 or 8, **characterized in that** the first part-area (122a) defines the switching area (123) and for that purpose a mark (134) is provided on the cover (112) above the first part-area (122a).

10. Sensor device according to one of Claims 7 to 9, **characterized in that** the two part-areas (122a, 122b) and the connecting area (122c) are a single layer with differing widths or contour and in particular applied on a single or identical process.

11. Sensor device according to one of Claims 7 to 10, **characterized in that** several switching areas (123) and conductive fields (122) are provided on the electrically insulating board (120) and are each subdivided into different two part-areas (122a, 122b), where an associated sensor element (115) in each case is at a distance from the associated switching area (123).

## Revendications

1. Dispositif capteur (11, 111) destiné à produire un signal de commutation à l'approche et/ou au contact d'une zone de commutation (23, 123) par un doigt ou un élément similaire d'un utilisateur
1.1 avec une commande électrique (30, 130) pour déclencher le signal de commutation,
1.2 avec exactement un élément capteur capacitif (15, 115) par zone de commutation (23, 123) qui est couplé galvaniquement à la commande électrique (30, 130),
1.3 avec un panneau (12, 112) en matériau non métallique présentant une face avant (13, 113) tournée vers l'utilisateur et une face arrière (14, 114),
1.4. avec une plaquette électriquement isolante (20, 120) sur laquelle l'élément capteur (15, 115) et la commande électrique (30, 130) sont disposés, et ce sur une face (32, 132) de la plaquette (20, 120) tournée dans le sens opposé à l'utilisateur et au panneau (12, 112),
1.5 et avec un champ conducteur (22, 122) qui est placé sur la face (33, 133) de la plaquette (20, 120) tournée vers le panneau (12, 112), sans être galvaniquement couplé à l'élément capteur,
1.6 sachant que la plaquette est disposée avec sa face (33, 133) portant le champ conducteur (22, 122) sur la face arrière (13, 113) du panneau (12, 112) dans la zone opposée à l'élément capteur (15, 115)
1.7 sachant que le champ conducteur (22, 122) définit la zone de commutation (23, 123),
1.8 **caractérisé en ce que** la zone de commutation (23, 123) et/ou le champ conducteur (22, 122) présente(nt) des dimensions considérablement supérieures à l'élément capteur (15, 115).

2. Dispositif capteur selon la revendication 1, **caractérisé en ce que** la zone de commutation (23, 123) et le champ conducteur (22, 122) présentent une autre forme et/ou une autre taille que l'élément capteur (15, 115).

3. Dispositif capteur selon l'une des revendications 1 ou 2, **caractérisé en ce que** l'élément capteur (15, 115) se trouve latéralement décalé par rapport au champ conducteur (22, 122).

4. Dispositif capteur selon l'une des revendications précédentes, **caractérisé en ce que**, pour produire plusieurs signaux de commutation différents, sont prévus plusieurs éléments capteurs identiques (15, 115) qui interagissent avec des champs électroconducteurs (22,122) le cas échéant de taille et/ou de conception différente(s)

5. Dispositif capteur selon l'une des revendications précédentes, **caractérisé en ce que** la plaquette (20, 120) et/ou le champ conducteur (22, 122) est collé(e) / sont collés sur la face arrière (14, 114) du panneau (12, 112).

6. Dispositif capteur selon l'une des revendications précédentes, **caractérisé en ce que** le champ conducteur (22, 122) et la plaquette (20, 120) sont collés au panneau (12, 112) au moyen d'une couche ou d'un film (35, 135) collant des deux côtés.

7. Dispositif capteur selon l'une des revendications précédentes, **caractérisé en ce que** le champ conducteur (122) est divisé en au moins deux zones partielles (122a, 122b), sachant que les deux zones partielles sont distantes l'une de l'autre et reliées entre elles par une zone de liaison (122c).

8. Dispositif capteur selon la revendication 7, **caractérisé en ce qu'**une deuxième zone partielle (122b) se trouve en face de l'élément capteur (115) et une première zone partielle conductrice (122a) se trouve à distance sans chevauchement de l'élément capteur (115), de préférence à une distance de deux à dix fois le diamètre de l'élément capteur (115) ou de la première zone partielle (122a).

9. Dispositif capteur selon la revendication 7 ou 8, **caractérisé en ce que** la première zone partielle (122a) définit la zone de commutation (123) et qu'un marquage (134) est prévu à cet effet sur le panneau (112) au-dessus de la première zone partielle (122a).

10. Dispositif capteur selon l'une des revendications 7 à 9, **caractérisé en ce que** les deux zones partielles (122a, 122b) et la zone de liaison (122c) sont une seule couche avec différentes largeurs ou différents contours, laquelle est en particulier appliquée en un seul et unique procédé.

11. Dispositif capteur selon l'une des revendications 7 à 10, **caractérisé en ce que** plusieurs zones de commutation (123) et champs conducteurs (122) sont disponibles sur la plaquette électriquement isolée (120), lesquelles zones sont respectivement réparties en différentes zones partielles (122a, 122b), sachant que respectivement un élément capteur (115) correspondant se trouve à distance de la zone de commutation (123) correspondante.
